# EUROPÄISCHE PATENTANMELDUNG

(11) **EP 1 359 628 A2**
(43) Veröffentlichungstag der Anmeldung: **05.11.2003**
(21) Anmeldenummer: 03009335.5
(22) Anmeldetag: 24.04.2003
(51) Int. Cl.: H01L 51/20

(54) **Verfahren zur Verkapselung eines Bauelements auf Basis organischer Halbleiter**

(30) Priorität: 03.05.2002 DE 10219951
(71) Anmelder: Patent-Treuhand-Gesellschaft für elektrische Glühlampen mbH, 81543 München (DE)
(72) Erfinder: Langer, Alfred, 86438 Kissing (DE); Messner, Ekkehard, Dr., 86163 Augsburg (DE)

(57) **Zusammenfassung**

Das Verfahren verwendet die folgenden Schritte:
a) Bereitstellen eines Substrats als Gehäuseteil mit darauf aufgebrachten elektrischen Anschlüssen, von weiteren Gehäuseteilen, die zumindest einen Deckel umfassen, und von Glaslot, wobei Substrat, Gehäuseteile und Glaslot im thermischen Ausdehnungskoeffizienten aufeinander angepasst sind, indem ihr thermischen Ausdehnungskoeffizienten weniger als 1,0 x 10⁻⁶K⁻¹ voneinander abweicht;
b) evtl. Vermengen des Glaslots mit einem Binder oder Lösungsmittel;
c) Auftragen des Glaslots zumindest auf den Deckel in Form einer umlaufenden Naht;
d) evtl. Austreiben des Binders oder Lösungsmittels;
e) Aufsintern des Lots;
f) Belegen des Substrats mit den das Halbleiterbauelement samt Elektroden repräsentierenden Schichten;
g) Auflegen des Deckels auf das Substrat;
h) lokales Aufheizen des Glaslots mittels einer Lichtquelle mit vorgegebener Peakwellenlänge.

## Beschreibung

### Technisches Gebiet

Die Erfindung geht aus von einem Verfahren zur Verkapselung eines Bauelements auf Basis organischer Halbleiter gemäß dem Oberbegriff des Anspruchs 1. Es handelt sich dabei insbesondere um sog. OLEDs, also organische lichtemittierende Geräte auf Basis der Elektrolumineszenz.

### Stand der Technik

Aus der WO 01/18 887 ist bereits ein Verfahren zur Verkapselung eines Bauelements auf Basis organischer Halbleiter bekannt, bestehend aus einem transparentem Substrat, einer darauf aufgebrachten Elektrode, lumineszierenden Schichten verschiedener Farben sowie einer Gegenelektrode. Das Halbleiterbauelement ist mittels eines Gehäuses luftdicht verkapselt, das mit dem Substrat durch Kleber verbunden ist.

Als Kleber wird ein UV-härtbarer Reaktionsklebstoff auf Epoxidharzbasis verwendet. Allerdings zeigen derartige organische Kleber keine befriedigende Dichtigkeit gegenüber Sauerstoff und Feuchtigkeit, was zu einem vorzeitigem Ausfall der OLED führt.

### Darstellung der Erfindung

Es ist Aufgabe der vorliegenden Erfindung, ein gekapseltes Halbleiterbauelement gemäß dem Oberbegriff des Anspruchs 1 bereitzustellen, das eine hohe Dichtigkeit aufweist.

Diese Aufgabe wird durch die kennzeichnenden Merkmale des Anspruchs 1 gelöst. Besonders vorteilhafte Ausgestaltungen finden sich in den abhängigen Ansprüchen.

Organische LEDs (OLED), insbesondere aus organischen LEDs aufgebaute Displays, bestehen aus einem Schichtpaket aus organischen Schichten (der eigentlichen OLED) und metallischen Schichten zum Kontaktieren (Elektroden), die sich zwischen zwei dünnen Glasplatten (z.B. 0,5 bis 1,0 mm dick) befinden. Diese bilden den Boden (Substrat) und den Deckel eines Gehäuses. Das Gehäuse kann weiterhin evtl. auch Seitenwände aufweisen. Diese Schichten würden ohne Verkapselung von Sauerstoff und Wasserdampf angegriffen, was zum Ausfall der OLED führt. Es wurde eine Verkapselung für die OLED entwickelt, die die restlichen Gehäuseteile mechanisch dauerhaft mit dem Substrat verbindet und die die OLED gasdicht umschließt und so vor Sauerstoff- und Feuchtigkeitsangriff schützt. Bei dem Verschluss darf die OLED nicht durch thermische Überbelastung beschädigt werden.

Es wurde eine Methode entwickelt, Substrat und restliche Gehäuseteile aus Glas, zwischen denen sich die OLED befindet, mit Hilfe eines bei relativ niedriger Temperatur schmelzenden Glaslotes, nämlich bei etwa 400 bis 600 °C, mechanisch stabil zu verbinden und die OLED gasdicht einzuschließen.

### Bei dem entwickelten Verfahren wird folgendermaßen vorgegangen:

Zunächst wird ein geeignetes Glaslot ausgewählt. Geeignet sind Glaslote, bei denen der Wert des thermischen Ausdehnungskoeffizienten nahe dem des zu verlötenden Glases liegt, bzw. etwas niedriger ist. Das Glaslot sollte insbesondere einen um höchstens 1,0 x 10⁻⁶K⁻¹ niedrigeren thermischen Ausdehungskoeffizienten haben, bevorzugt ist er um 0,1 bis 0,4 x 10⁻⁶K⁻¹ niederiger. Dabei liegt ein typischer Absolutwert des thermischen Ausdehnungskoeffizienten des Glaslots bei etwa 7,0 x 10⁻⁶K⁻¹ . Außerdem muss das Lot bei einer Temperatur verarbeitbar sein, bei der das zu verlötende Glas noch nicht erweicht. Gut geeignet ist eine Verarbeitungstemperatur des Glaslots, die um 100 bis 200 K niedriger als die Erweichungstemperatur des zu verlötenden Glases ist. Bei Verwendung eines organischen Binders oder Lösungsmittels zum Aufbringen des Lots darf das Lot erst bei einer Temperatur erweichen und Poren schließen, wenn der Binder bereits ausgetrieben worden ist. In Frage kommen unter anderem Blei-, Borat- und Phosphatgläser als Glaslot, bei denen man vorteilhaft durch Zugabe von absorbierenden Zusätzen wie FeO die Absorptionseigenschaften zur Einkopplung einer aufheizenden Strahlung, die insbesondere im Infrarotbereich bei etwa 780 bis 1100 nm liegt, verbessern kann. Der Hintergrund dafür ist, dass das Glaslot dann optimal darauf eingestellt ist, durch Absorption von geeigneter Laserstrahlung (oder sonstiger Strahlungs- bzw. Licht- Emission) erweicht oder verflüssigt zu werden.

In einem zweiten Schritt wird das Lot auf das Substrat aufgebracht. Dafür kommen mehrere Verfahren in Frage:
a) Linienförmiger Auftrag des Glaslotes auf die Innenseite des Deckels, also der oberen Glasscheibe. Das Lot, z. B. CERDEC 10104 der Fa. CERDEC AG, liegt dabei als Paste oder Suspension vor. Hierbei muss ein möglichst niedrig schmelzendes Lot verwendet werden, um beim Lötvorgang die OLED nicht thermisch zu schädigen. Dabei kann das Aufbringen mit Hilfe einer Methode, die einen gleichmäßigen Auftrag des Lots ermöglicht, geschehen, insbesondere mittels eines Dispensers oder durch Siebdruck. Danach erfolgt eventuell Trocknen oder Abkühlen des aufgetragenen Lots, zum Erreichen einer besseren Handhabbarkeit des Deckels.
   Der nächste Schritt ist das Austreiben des organischen Binders (z. B. ELVACITE 2045 der Fa. ICI ACRYLICS) oder des Lösungsmittels aus dem Glaslot. Das Austreiben erfolgt durch Ausheizen in einer geeigneten (in der Regel oxidierenden) Atmosphäre. Glaslot und Binder müssen so aufeinander abgestimmt sein, dass sich der Binder bei einer Temperatur austreiben lässt, bei der das Glaslot noch nicht erweicht. Es ist aber auch die Verwendung anderer Bindersysteme denkbar, bei denen ein Teil der Entbinderung durch Herauslösen erfolgt. Ebenso ist die Verwendung einer binderfreien Suspension möglich, bei der nach dem Auftrag nur das Lösungsmittel, beispielsweise Wasser oder Alkohol, entfernt werden muss.
b) alternativ das unter a) beschriebene Verfahren, wobei sich als zusätzlicher Verfahrensschritt das Aufsintern des Lotes auf den Deckel anschließt.
c) alternativ das unter a) oder b) beschriebene Verfahren (Aufbringen des Lots auf den Deckel wie dort beschrieben), wobei zusätzlich Lot möglichst deckungsgleich zum Deckel auf die untere Glasscheibe (das Substrat) aufgebracht wird. Das Substrat wird vor dem Auftragen der Lotpaste bzw. der Lotsuspension bereits mit metallischen Leiterbahnen (z.B. Kupfer- oder Aluminiumlegierungen) für die Kontaktierung der OLED bzw. des OLED-Arrays belegt.
   Bei dem Entbindern und dem Aufsintern des Lots auf das Substrat ist dabei zu beachten, dass keine oxidierende Atmosphäre verwendet wird (bevorzugt ist Vakuum) und keine Temperatur überschritten wird, bei der die Leiterbahnen beschädigt werden. Das heißt, dass die Schmelztemperatur der Metalle der Leiterbahnen nicht überschritten werden soll, typisch ist ein Wert von 600 °C im Falle der Verwendung von Aluminium. Das Substrat muss dann, nach dem Aussintern des Lots, mit den OLED-Schichten belegt werden.
d) alternativ Verwendung binderfrei verpresster Lotstreifen, die direkt vor dem eigentliche Lötvorgang eingelegt und positioniert werden.
e) alternativ Verwendung eines pulverförmigen Lots ohne Binder. Das Aufbringen auf den Deckel erfolgt durch dosiertes Aufrieseln. Zum Erzeugen einer "Glasraupe" (damit ist ein Wall oder eine Naht gemeint um die Handhabbarkeit zu erreichen) kann man es mit einer scharfen Flamme oder Laser direkt beim Aufrieseln zum Aufschmelzen bringen. Ein anderer Weg ist, dass man das (Flach-)Glas mit dem Lot zum Aufschmelzen des Lots in einen Ofen gibt, oder das Lot direkt auf die vorgeheizte Glasplatte rieseln lässt um das Lot aufzuschmelzen.
f) alternativ kann das Verfahren nach e) so modifiziert werden, dass das Lot auch auf das Substrat aufgetragen wird. Das Aufschmelzen im Ofen bzw. das Aufrieseln auf die vorgeheizte Platte, eventuell unter einer Schutzatmosphäre, ist besonders für den Auftrag auf das Substrat geeignet, da sich auf diesem bereits die metallischen Leiterbahnen befinden, die durch eine Flamme oder Laserstrahlung beschädigt werden können. Das Substrat muss dann, nach dem Aussintern des Lots, mit den OLED-Schichten belegt werden.

Der nächste grundlegende Verfahrensschritt ist das Aufheizen des Lots mit einem Laser oder einer sonstigen gebündelten Lichtquelle (Löten mit Laser). Organische LEDs sind nur gering temperaturbelastbar. Eine Erwärmung über 100 °C ist nur einige Minuten zulässig, eine Erwärmung auf 150 °C sollte nicht länger als 1 - 2 Minuten dauern. Daher muss das Lot lokal begrenzt erhitzt werden.

Das Löten mit einem Laserstrahl hat den Vorteil, dass man die zur Lötung nötige starke Erwärmung des Lotes und der beiden Glasscheiben auf einen engen Raum begrenzen kann und so die Schädigung der OLED vermeidet.

Besonders geeignet sind Nd-YAG-Laser (Emission bei 1060 nm), gepulst oder kontinuierlich (CW), oder Dioden-Laser (Emission bei 808 nm oder 940 nm). Die genannten Wellenlängen liegen in einem Infrarotbereich, in dem das zu verlötende Flachglas noch gut durchlässig ist, so dass die Laserstrahlung direkt in das Lot einkoppeln kann und so im Lot der Großteil der Wärmeentwicklung stattfindet.

Wenn sich die Lotnaht am Rande der beiden Displayglasscheiben befindet, kann man die zueinander angeordneten Kanten der Scheiben, insbesondere des Deckels, anfasen, um Platz für herausquellendes Lot zu schaffen.

Für diesen Lötvorgang kommen mehrere Verfahren in Frage:
a) Nach dem Auflegen des Deckels durchstrahlt der Laser den Deckel, fährt dabei die Lotraupe ab, bringt das Lot zum Aufschmelzen und verschmilzt so die beiden Scheiben. Nur das Deckelglas muss dazu IR-durchlässig für die Bestrahlung zum Ausheizen sein, bevorzugt also im Bereich 780 bis 1100 nm.
b) alternativ kann das Verfahren nach a) so modifiziert werden, dass zusätzlich ein Laser gleichzeitig auch durch das Substrat strahlt und dabei die Lotraupe von der anderen Seite erwärmt. Dabei muss der Laser die zahlreichen Stellen aussparen, bzw. die Bestrahlungsintensität stark vermindern, bei denen die Spur des Lots die verschiedenen Leiterbahnen kreuzt. In diesem Fall muss auch das Substrat ähnlich wie der Deckel IR-durchlässig sein.
c) alternativ erfolgt die Erwärmung der gesamten Lotnaht zur gleichen Zeit durch ein geeignetes Diodenlaser-Array. Das Diodenlaser-Array strahlt dabei durch den Deckel, oder durch den Deckel und das Substrat. Damit wird ein gleichzeitiges Erweichen der gesamten Naht erreicht. Durch das damit mögliche gleichmäßige Annähern der beiden Displayscheiben unter dem Eigengewicht der obenliegenden Scheibe oder durch einen Anpressdruck lässt sich ein besserer Kontakt zwischen Glaslot und den zu verbindenden Glasscheiben erreichen. Auch hier gilt bzgl. IR-Durchlässigkeit das unter a) und b) Gesagte.
d) Bei allen genannten Lötverfahren lässt sich ein Laser mit reduzierter Leistung pro Fläche, z.B. durch eine defokussierte Einstellung oder Reduktion der absoluten Leistung, auch zum Vorwärmen oder Nachwärmen verwenden, um einer Rissbildung durch den konzentrierten Wärmeeintrag oder den daraus resultierenden temperbaren Verspannungen vorzubeugen.
e) Bei allen Lötverfahren lässt sich durch eine geeignete Vorrichtung das Löten auch unter Schutzgas durchführen, um Dioden-Array und Leiterbahnen auf eine geeignete Weise zu schützen.

### Kurze Beschreibung der Zeichnungen

Im folgenden soll die Erfindung anhand mehrerer Ausführungsbeispiele näher erläutert werden. Es zeigen:
- Figur 1: ein OLED-Array von oben gesehen;
- Figur 2: eine Seitenansicht dieses Ausführungsbeispiels;
- Figur 3: die Seitenansicht eines weiteren Ausführungsbeispiels.

### Bevorzugte Ausführung der Erfindung

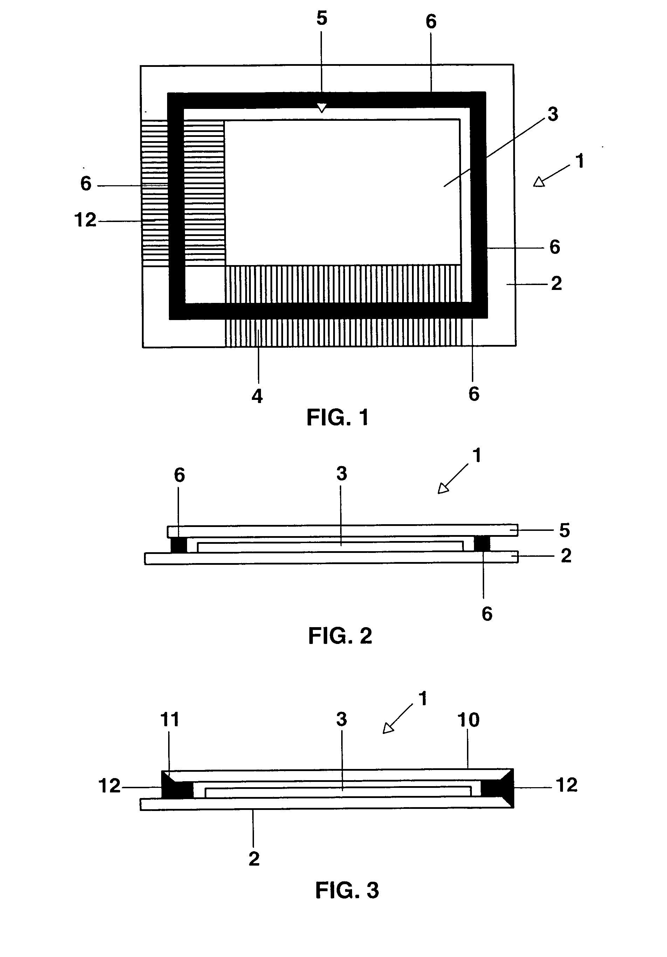

Figur 1 zeigt in Draufsicht ein typisches OLED. Die Seitenansicht ist in Figur 2 dargestellt. Die OLED 1 besteht aus einem Substrat 2, auf dem ein OLED-Array aus Pixeln 3 aufgebracht ist. Dieses besteht in bekannter Weise aus Elektroden 4, elektrolumineszenten organischen Leuchtstoffen in Schichten aufgebracht und Gegenelektroden 12. Von den Elektroden 4 und Gegenelektroden 12 sind jeweils die nach außen führenden Leiterbahnanschlüsse sichtbar.

Das Gehäuse ist durch ein im Sichtbaren und nahen IR transparentes Flachglas als Deckel 5 realisiert, wobei die Seitenwände 6 ganz oder teilweise aus Glaslot gefertigt sind. Das Glaslot bildet dabei einen Wall, oft als Raupe oder Naht bezeichnet. Der Deckel 5 ist eine flache Scheibe mit senkrechten Wänden.

In einer weiteren bevorzugten Ausführungsform (Figur 3) besitzt der Deckel 10 der OLDE 1 abgeschrägte Seitenwände 11 (sog. Fasen), so dass das als Seitenwand des Gehäuses wirkende Lot 12 besonders dickwandig aufgetragen werden kann und der Kontakt zwischen Lot 12 und Deckel 10 verbessert wird, so dass eine besonders zuverlässige Abdichtung erzielt wird.

Das Herstellverfahren läuft so ab, dass als Substrat und Deckel jeweils ein Flachglas, beispielsweise das Sodaline Displayglas der Fa. Merck verwendet wird. Als Glaslot wird ein bezüglich des thermischen Ausdehnungskoeffizienten angepasstes Glaslot der Fa. Cerdec (Cerdec 10104) verwendet. Diesem kann evtl. ein Zusatz von 2 Gew.-% Fe2O3 hinzugefügt werden, um die IR-Absoprtionsfähigkiet zu verbessern. Des weiteren wird ein Binder dem Glaslot zugemengt, geeignet ist beispielsweise Cerdec 80858 oder ICI Elvacite 2045. Wichtig ist, dass sich der Binder unterhalb der Erweichungstemperatur des Glaslots (bei Cerdec 10104 beträgt sie 440 °C) austreiben lässt.

Gut geeignet ist ein Zusatz von 1 bis 4 Gew.-% Fe2O3. Andere geeignete Zusätze als Absorber sind Metalloxide, die je nach gewünschter Absorptionsfähigkeit ausgewählt werden.

Bei Verwendung von Elvacite als Binder wurde das Lot zunächst bei 400 °C ausgeheizt und bei 500 °C anschließend am Substrat angesintert. Anschließend erfolgte die Aufschmelzung mittels eines Nd-YAG-Lasers, der gepulst betrieben wurde. Mittels Pulsdauer und Totzeit lässt sich die Belastung des Materials genau dosieren.

Alternativ wurde als Binder Cerdec 80858 eingesetzt. Dieser wurde bei 420 °C ausgeheizt und das Glaslot dann bei 520 °C am Substrat und am Deckel angesintert. Das Aufschmelzen erfolgte mittels eines kontinuierlichen Nd-YAG-Lasers.

Eine weitere Alternative ist die Verwendung eines IR-Diodenlasers oder CO2-Lasers, wie es in anderem Zusammenhang (siehe WO 00/12256) bekannt ist.

Bei einer anderen Ausführungsform besitzt das Gehäuse separate Seitenwände aus Glas, wobei das Glaslot jeweils zwischen den Seitenwänden und dem Deckel bzw. Substrat eingebracht wird.

## Patentansprüche

1. Verfahren zur Verkapselung eines Bauelements auf Basis organischer Halbleiter, **dadurch gekennzeichnet, dass** folgende Verfahrensschritte angewendet werden:
a) Bereitstellen eines Substrats als Gehäuseteil mit darauf aufgebrachten elektrischen Anschlüssen, von weiteren Gehäuseteilen, die zumindest einen Deckel umfassen, und von Glaslot, wobei Substrat, weitere Gehäuseteile und Glaslot im thermischer Ausdehnungskoeffizient aufeinander angepasst sind, indem ihr thermischen Ausdehnungskoeffizienten weniger als 1,0 x 10⁻⁶K⁻¹ voneinander abweicht;
b) evtl. Vermengen des Glaslots mit einem Binder oder Lösungsmittel;
c) Auftragen des Glaslots zumindest auf den Deckel in Form eines umlaufenden Walls (Naht oder Raupe)
d) evtl. Austreiben des Binders oder Lösungsmittels;
e) Aufsintern des Lots;
f) Belegen des Substrats mit den das Halbleiterbauelement samt Elektroden repräsentierenden Schichten;
g) Auflegen des Deckels auf das Substrat;
h) lokales Aufheizen des Glaslots mittels einer Lichtquelle mit vorgegebener Peakwellenlänge.

2. Verfahren nach Anspruch 1, **dadurch gekennzeichnet, dass** dem Glaslot zusätzlich in Schritt b) ein zumindest die Peakwellenlänge der Lichtquelle absorbierendes Mittel, insbesondere Eisenoxid, beigemengt wird.

3. Verfahren nach Anspruch 1, **dadurch gekennzeichnet, dass** im Schritt c) das Glaslot auch auf das Substrat aufgetragen wird.

4. Verfahren nach Anspruch 1, **dadurch gekennzeichnet, dass** im Schritt c) das das Auftragen des Glaslots durch Aufrieseln eines pulverförmigen Glaslots erfolgt.

5. Verfahren nach Anspruch 1, **dadurch gekennzeichnet, dass** die Lichtquelle ein im nahen IR bei 780 bis 1100 nm absorbierender Laser ist.

6. Verfahren nach Anspruch 1, **dadurch gekennzeichnet, dass** ein zusätzlicher Verfahrensschritt des Vor- u/o Nacherwärmens des Glaslots durch die vorgegebene Lichtquelle stattfindet.

7. Verfahren nach Anspruch 1, **dadurch gekennzeichnet, dass** das Gehäuse des weiteren separate Seitenwände umfasst.

8. Gekapseltes Halbleiterbauelement nach einem der vorhergehenden Ansprüche.
